# EUROPEAN PATENT APPLICATION

(11) **EP 3 735 107 A1**
(43) Date of publication of application: **04.11.2020**
(21) Application number: 18894378.1
(22) Date of filing: 12.12.2018
(51) Int. Cl.: H05B 33/10, H01L 51/50, H05B 33/22, H05B 33/26

(54) **METHOD FOR PRODUCING ELECTRONIC DEVICE, AND ELECTRONIC DEVICE**

(30) Priority: 26.12.2017 JP 2017249443
(71) Applicant: SUMITOMO CHEMICAL COMPANY, LIMITED, Chuo-ku, Tokyo 104-8260 (JP)
(72) Inventor: INOUE Hiroyasu, Niihama-shi, Ehime 792-0015 (JP); KISHIKAWA Eiji, Niihama-shi, Ehime 792-0015 (JP); SHAKUTSUI Masato, Niihama-shi, Ehime 792-0015 (JP)
(74) Representative: J A Kemp LLP
(86) International application number: PCT/JP2018/045735
(87) International publication number: WO 2019/131145

(57) **Abstract**

A method for producing an electronic device 1 includes: a preparation step of preparing a substrate 2 with an electrode having a first electrode layer 20 on a substrate 10, where the first electrode layer includes a first conductive layer 21 and a second conductive layer 22 disposed on the first conductive layer, and an eaves part 24 in which the second conductive layer projects outside the first conductive layer is formed in at least a part of a predetermined region A of an edge of the first electrode layer when viewed from a thickness direction of the substrate; a device functional part forming step of forming a device functional part 30 on the first electrode layer; a second electrode layer forming step of forming a second electrode layer on the device functional part so that a part of the second electrode layer is disposed on the predetermined region; and a non-conductive part forming step of forming a non-conductive part 40 on the at least a part of the predetermined region before the second electrode layer forming step.

## Description

### TECHNICAL FIELD

The present invention relates to a method for producing an electronic device, and an electronic device.

### BACKGROUND ART

An electronic device includes a substrate with an electrode that has a substrate and a first electrode layer on the substrate, a device functional part, and a second electrode layer. The electronic device is produced by forming the device functional part and the second electrode layer in this order on the first electrode layer included in the substrate with an electrode.

The transparent conductor described in Patent Document 1 is an example of the substrate with an electrode. The transparent conductor is a laminate including a transparent substrate, a first high refractive index layer, a transparent metal film, and a second high refractive index layer in this order. A multi-layer structure including the first high refractive index layer, the transparent metal film, and the second high refractive index layer functions as a first electrode layer.

### PRIOR ART DOCUMENTS

### PATENT DOCUMENT

Patent Document 1: WO 2014/167835

### SUMMARY OF THE INVENTION

### PROBLEMS TO BE SOLVED BY THE INVENTION

Patent Document 1 discloses, for example, the following method as a method for producing a first electrode layer including a first high refractive index layer, a transparent metal film, and a second high refractive index layer. First, the first high refractive index layer, the transparent metal film, and the second high refractive index layer are formed on a transparent substrate. A multi-layer structure including the first high refractive index layer, the transparent metal film, and the second high refractive index layer is then pattered in a desired shape using an etchant, so that the first electrode layer is formed.

However, since the first high refractive index layer, the transparent metal film, and the second high refractive index layer are made of different materials, etching rates of these layers are also different from each other. For this reason, when the first electrode layer formed as described above is viewed in a thickness direction of the multi-layer structure, the second high refractive index layer projects outward from an edge of the transparent metal film, and the projecting portion of the second high refractive index layer from the transparent metal film forms an eaves part. When an electronic device is produced using the first electrode layer with such an eaves part, the eaves part may be bent to the opposite side to the substrate during a production process, so that a projection may be formed. If the projection is formed, sufficient insulation between the first electrode layer including the projection and the second electrode layer cannot be achieved. As a result, a short circuit occurs between the first electrode layer and the second electrode layer or current leakage occurs.

An object of the present invention is to provide a method for producing an electronic device and an electronic device that can more reliably insulate the first electrode layer from the second electrode layer.

### MEANS FOR SOLVING THE PROBLEMS

One aspect of the present invention includes a preparation step of preparing a substrate with an electrode having a first electrode layer on a substrate, where the first electrode layer includes a first conductive layer and a second conductive layer that is disposed to be opposite to the substrate with respect to the first conductive layer , and an eaves part in which the second conductive layer projects outside the first conductive layer is formed in at least a part of a predetermined region of an edge of the first electrode layer when viewed from a thickness direction of the substrate, a device functional part forming step of forming a device functional part including one or a plurality of functional layers on the first electrode layer included in the substrate with an electrode, a second electrode layer forming step of forming a second electrode layer on the device functional part, where the second electrode layer is formed so that a part of the second electrode layer is disposed on the predetermined region, and a non-conductive part forming step of forming a non-conductive part on the at least a part of the predetermined region before the second electrode layer forming step.

In the production method described above, the non-conductive part is formed on the at least a part of the predetermined region at the non-conductive part forming step before the second electrode layer forming step. Consequently, even when the eaves part of the first electrode layer included in the substrate with an electrode prepared at the preparation step is, for example, bent to the opposite side to the substrate and thus a projection is formed, the non-conductive part is disposed between the projection and the second electrode layer. It is thus possible to more reliably insulate the first electrode layer from the second electrode layer.

At the non-conductive part forming step, the non-conductive part may be formed on an entire predetermined region. In this case, even when the eaves part is deformed and thus the projection is formed, the non-conductive part is reliably disposed between the projection and the second electrode layer, regardless of the position where the projection is formed in the predetermined region. It is thus possible to more reliably insulate the first electrode layer from the second electrode layer.

At the device functional part forming step, the device functional part may be formed inside the first electrode layer when viewed from a thickness direction of the substrate.

At the non-conductive part forming step, the non-conductive part may be formed so as to, if the eaves part is deformed and thus a projection is formed on an opposite side to the substrate, isolate the projection from the second electrode layer. It is thus possible to more reliably insulate the first electrode layer from the second electrode layer.

The second conductive layer has a projection on an opposite side to the substrate in the at least a part of the predetermined region, and at the non-conductive part forming step, the non-conductive part may be formed so as to isolate the projection from the second electrode layer. In this case, as the non-conductive part is reliably disposed between the projection and the second electrode layer, it is possible to more reliably insulate the first electrode layer from the second electrode layer.

At the non-conductive part forming step, the non-conductive part may be formed by coating a photosensitive resin composition on the at least a part of the predetermined region and curing the photosensitive resin composition by light irradiation. In this case, the non-conductive part is a cured product of the photosensitive resin composition.

The preparation step may include a step of forming a first material layer containing a same material as a material of the first conductive layer and a second material layer containing a same material as a material of the second conductive layer on the substrate in an order of the first material layer and the second material layer and a step of patterning the first material layer and the second material layer together into a predetermined pattern by etching, thus forming the first electrode layer, wherein the material of the second conductive layer may be a material having a lower etching rate than the material of the first conductive layer in the etching.

In this case, since the etching rate of the material of the second material layer that becomes the second conductive layer is lower than the etching rate of the material of the first material layer that becomes the first conductive layer, the eaves part is formed in the second conductive layer.

An electronic device according to another aspect of the present invention includes a substrate, a first electrode layer on the substrate, a device functional part that is disposed on the first electrode layer and includes one or a plurality of function layers, a second electrode layer that is disposed on the device functional part, where a part of the second electrode layer is disposed on a predetermined region of an edge of the first electrode layer, and a non-conductive part between at least a part of the predetermined region and the second electrode layer, wherein the first electrode layer includes a first conductive layer and a second conductive layer disposed closer to the device functional part than the first conductive layer, and the second conductive layer includes a projection on an opposite side to the substrate in the at least a part of the predetermined region.

In the electronic device described above, the non-conductive part is disposed between the projection of the second conductive layer and the second electrode layer. It is thus possible to more reliably achieve insulation between the first electrode layer and the second electrode layer.

The non-conductive part may be disposed on an entire predetermined region. The device functional part may be disposed inside the first electrode layer when viewed from a thickness direction of the substrate.

The non-conductive part may contain an insulating material. Consequently, the non-conductive part may have an insulating property.

The non-conductive part may be a cured product of the photosensitive resin composition. A material of the non-conductive part may be a material contained in one or a plurality of functional layers included in the device functional part.

Examples of a material of the first conductive layer may include at least one metal selected from the group consisting of silver, gold, aluminum, copper, iron, palladium, rhodium, titanium, chromium, and molybdenum or an alloy containing the one metal.

The first electrode layer may further include a metal oxide layer between the first conductive layer and the substrate.

At least one functional layer included in the device functional part may be a light emitting layer containing an organic material. In this case, the electronic device is an organic electroluminescent device.

### EFFECT OF THE INVENTION

According to the present invention, it is possible to provide the method for producing an electronic device and the electronic device that can more reliably insulate the first electrode layer from the second electrode layer.

### BRIEF DESCRIPTION OF THE DRAWINGS

Fig. 1 is a plan view of a substrate with an electrode used for producing an electronic device according to an embodiment.
Fig. 2 is a cross-sectional view along a line II-II of Fig. 1.
Fig. 3 is a view for explaining a method for producing an electronic device according to an embodiment.
Fig. 4 is a cross-sectional view along a line IV-IV of Fig. 3.
Fig. 5 is a view for explaining a modification of the electronic device according to an embodiment.
Fig. 6 is a cross-sectional view along a line VI-VI of Fig. 5.

### MODE FOR CARRYING OUT THE INVENTION

Hereinafter, embodiments of the present invention will be described with reference to the drawings. The same components are denoted by the same reference numerals, and duplicated description will be omitted. Dimensional ratios in the drawings do not necessarily match those in the description.

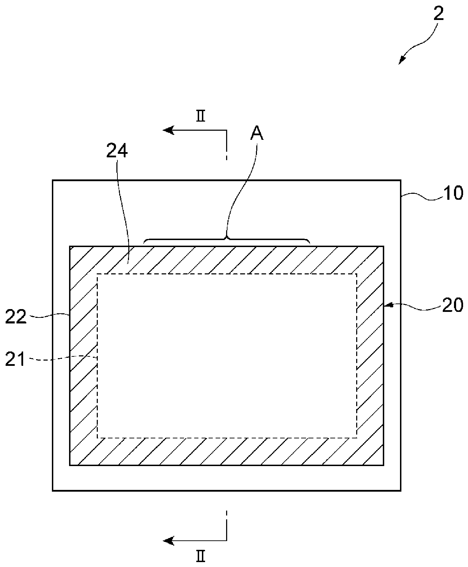

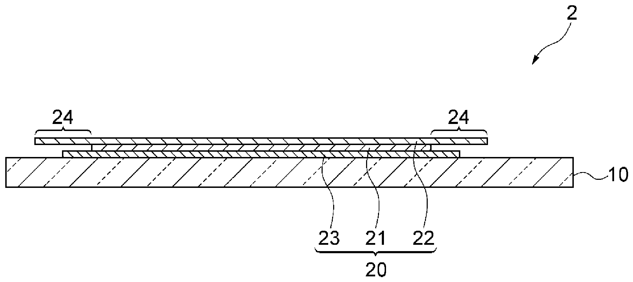

Fig. 1 is a plan view of a substrate with an electrode used for producing an electronic device according to an embodiment. Fig. 2 is a cross-sectional view along a line II-II in Fig. 1. In the present embodiment, the electronic device is an organic electroluminescent device (organic EL device) that emits light from a side of a substrate with an electrode, unless otherwise specified. An example of the organic EL device is an organic EL lighting device. As illustrated in Fig. 1 and Fig. 2, a substrate 2 with an electrode includes an anode layer (first electrode layer) 20 on a substrate 10.

### [Substrate]

The substrate 10 has a light transmitting property with respect to light (including visible light having wavelength of 400 nm to 800 nm) emitted from an organic EL device (electronic device) to be produced.

The substrate 10 may have flexibility. The flexibility means the property that allows a substrate to be flexible without shearing or breaking even when a predetermined force is applied to the substrate. Examples of the substrate 10 with flexibility include a plastic film and a polymer film, and these films have a thickness of, for example, 30 µm to 700 µm. The substrate 10 may be made of glass, and has a thickness of, for example, 0.05 mm to 1.1 mm. The substrate 10 may further include a barrier layer having a moisture barrier function. The barrier layer may have, in addition to the function of blocking moisture, a function of blocking gas (for example, oxygen).

### [Anode Layer]

The anode layer 20 is disposed on the substrate 10. The anode layer 20 has the light transmitting property with respect to light emitted from an organic EL device to be produced. The anode layer 20 may have a network structure. The anode layer 20 is a laminate having a first conductive layer 21 and a second conductive layer 22. The second conductive layer 22 and the substrate 10 are disposed to be opposite to each other with the first conductive layer 21 being provided between the second conductive layer 22 and the substrate 10. The anode layer 20 may further include a metal oxide layer 23 between the first conductive layer 21 and the substrate 10. Hereinafter, unless otherwise specified, the anode layer 20 has the metal oxide layer 23. In this case, the anode layer 20 has the metal oxide layer 23, the first conductive layer 21, and the second conductive layer 22, and has a three-layer structure in which the metal oxide layer 23, the first conductive layer 21, and the second conductive layer 22 are laminated from a side of the substrate 10.

An example of the first conductive layer 21 is a metal layer, and the metal layer contains, for example, at least one metal selected from the group consisting of silver (Ag), gold (Au), aluminum (Al), copper (Cu), iron (Fe), palladium (Pd), rhodium (Rh), titanium (Ti), chromium (Cr), and molybdenum (Mo) or an alloy containing one metal mentioned above. The metal layer preferably contains silver or a silver alloy. The thickness of the first conductive layer 21 may be any thickness as long as light emitted by the organic EL device to be produced can be transmitted. The first conductive layer 21 may be formed as a thin film. An example of the thickness of the first conductive layer 21 is 5 nm to 15 nm, preferably 7 nm to 9 nm.

The second conductive layer 22 is laminated on the first conductive layer 21. The second conductive layer 22 is a transparent conductive film that has the light transmitting property with respect to light emitted from the organic EL device to be produced. The material of the second conductive layer 22 is different from the material of the first conductive layer 21. The material of the second conductive layer 22 may be a material having a lower etching rate than the first conductive layer 21 when, for example, the first conductive layer 21 and the second conductive layer 22 are simultaneously etched (in other words, etched with same etchant). Examples of the material of the second conductive layer 22 include indium tin oxide (ITO) and indium zinc oxide (IZO). An example of the thickness of the second conductive layer 22 is 10 nm to 100 nm, preferably 70 nm to 80 nm.

The metal oxide layer 23 is disposed between the substrate 10 and the first conductive layer 21. Examples of the material of the metal oxide layer 23 include indium oxide, zinc oxide, tin oxide, and titanium oxide. The thickness of the metal oxide layer 23 may be any thickness as long as light emitted by the organic EL device to be produced can be transmitted. An example of the thickness of the metal oxide layer 23 is 30 nm to 70 nm, preferably 50 nm to 60 nm.

When the anode layer 20 is viewed from the thickness direction of the substrate 10, at least in a predetermined region A of the edge of the anode layer 20, the second conductive layer 22 includes an eaves part 24 having an eaves shape and overhanging the first conductive layer 21. The eaves part 24 is a part of the second conductive layer 22 that projects outside the first conductive layer 21. Fig. 1 and Fig. 2 illustrate a case where the eaves part 24 is formed on the entire edge of the anode layer 20. In Fig. 1, the eaves part 24 is hatched for convenience of description. The predetermined region A is a region in the organic EL device where the edge of the anode layer 20 overlaps a cathode layer paired with the anode layer 20 when viewed from the thickness direction of the substrate 10.

The anode layer 20 may be formed, for example, as follows. First, on the substrate 10, a third material layer, a first material layer, and a second material layer are sequentially formed in a region on the substrate 10 wider than an anode layer forming region (for example, entire surface of substrate 10) using materials of the metal oxide layer 23, the first conductive layer 21, and the second conductive layer 22. The third material layer, the first material layer, and the second material layer are layers that become the metal oxide layer 23, the first conductive layer 21, and the second conductive layer 22, respectively.

The third material layer, the first material layer, and the second material layer may be formed by, for example, a dry film forming method, a plating method, a coating method, or the like. Examples of the dry film forming method include a vacuum evaporation method, a sputtering method, an ion plating method, a CVD method, and the like. Examples of the coating method include inkjet printing, slit coating, microgravure coating, gravure coating, bar coating, roll coating, wire bar coating, spray coating, screen printing, flexographic printing, offset printing, nozzle printing, and the like.

Next, the third material layer, the first material layer, and the second material layer that are formed on the substrate 10 are etched so that the first material layer and the second material layer are patterned together into a predetermined pattern. As a result, the anode layer 20 is obtained on the anode layer forming region. Since the materials of the third material layer, the first material layer, and the second material layer are different from each other, etching rates of these layers are also different at the time of the etching. As the etching rate of the second material layer is normally lower than that of the first material layer, the eaves part 24 described above is formed.

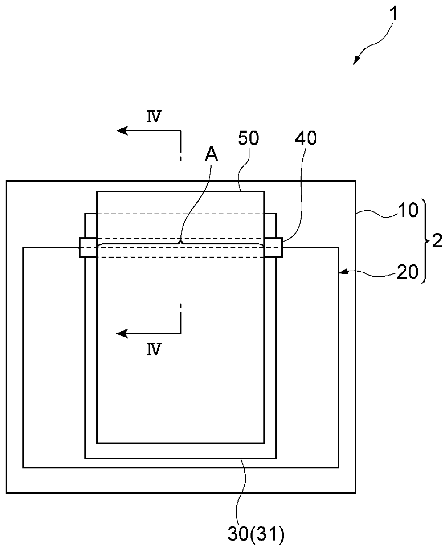

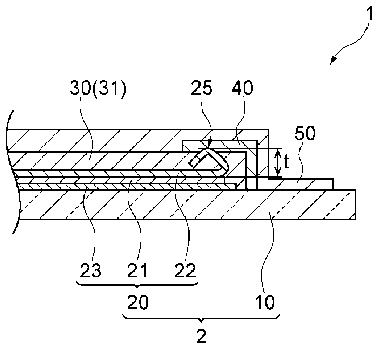

Next, an example of a method for producing an organic EL device 1 illustrated in Fig. 3 and Fig. 4 using the substrate 2 with an electrode will be described. The method for producing the organic EL device 1 mainly includes a preparation step, a device functional part forming step, a non-conductive part forming step, and a cathode layer forming step (second electrode layer forming step). Each of these steps will be described.

### [Preparation Step]

At the preparation step, the substrate 2 with an electrode illustrated in Fig. 1 and Fig. 2 is prepared. At the preparation step, the substrate 2 with an electrode may be prepared by purchasing the substrate 2 with an electrode. Alternatively, the substrate 2 with an electrode may be prepared by forming the anode layer 20 on the substrate 10 using the example of the method for forming the anode layer 20 described above.

After the preparation step and before the device functional part forming step, for example, a cleaning step of cleaning (performing surface treatment on) the surface of the substrate 2 with an electrode may be performed.

### [Device Functional Part Forming Step]

At the device functional part forming step, a device functional part 30 is formed on the anode layer 20 included in the substrate 2 with an electrode. The device functional part 30 is formed so as to expose a part of the anode layer 20 for external connection and to cover the predetermined region A. As the device functional part 30 covers the predetermined region A, a part of the device functional part 30 contacts the substrate 10.

The device functional part 43 is a functional part that contributes to light emission of the organic EL device 1 such as movements of charges and recombination of charges, according to voltages applied to the anode layer 20 and a cathode layer 50. The device functional part 43 has one or a plurality of functional layers. Fig. 3 and Fig. 4 illustrate an embodiment in which the device functional part 30 has a single-layer structure, in other words, an embodiment in which the device functional part 30 is a light emitting layer 31.

The light emitting layer 31 is a functional layer having a function of emitting light (including visible light). The light emitting layer 31 normally contains an organic material that mainly emits at least one of fluorescence and phosphorescence, or the organic material and a dopant material that assists the organic material. The light emitting layer 31 is thus an organic layer (layer containing organic material). The dopant material is added, for example, at least either to improve emission efficiency or to change an emission wavelength. The organic material may be a low molecular compound or a high molecular compound. The thickness of the light emitting layer is, for example, 2 nm to 200 nm.

Examples of the organic material that mainly emits at least one of fluorescence and phosphorescence include the following dye-based materials, metal complex-based materials, and polymer-based materials.

### (Dye-Based Material)

Examples of the dye-based material include cyclopendamine derivatives, tetraphenylbutadiene derivative compounds, triphenylamine derivatives, oxadiazole derivatives, pyrazoloquinoline derivatives, distyrylbenzene derivatives, distyrylarylene derivatives, pyrrole derivatives, thiophene ring compounds, pyridine ring compounds, perinone derivatives, perylene derivatives, oligothiophene derivatives, oxadiazole dimers, pyrazoline dimers, quinacridone derivatives, coumarin derivatives, and the like.

### (Metal Complex-Based Material)

Examples of the metal complex-based material include metal complexes having a rare earth metal such as Tb, Eu, or Dy, or Al, Zn, Be, Ir, Pt, or the like as a central metal and having oxadiazole, thiadiazole, phenylpyridine, phenylbenzimidazole, or a quinoline structure as a ligand. Examples of the metal complexes include metal complexes emitting light in a triplet excited state such as an iridium complex and a platinum complex, an aluminum quinolinol complex, a benzoquinolinol beryllium complex, a benzooxazolyl zinc complex, a benzothiazole zinc complex, an azomethyl zinc complex, a porphyrine zinc complex, a phenanthroline europium complex, and the like.

### (Polymer-Based Material)

Examples of the polymer-based material include polyparaphenylenevinylene derivatives, polythiophene derivatives, polyparaphenylene derivatives, polysilane derivatives, polyacetylene derivatives, polyfluorene derivatives, polyvinyl carbazole derivatives, materials in which the dye-based material and the metal complex-based light-emitting material are polymerized, and the like.

### (Dopant Material)

Examples of the dopant material include perylene derivatives, coumarin derivatives, rubrene derivatives, quinacridone derivatives, squarium derivatives, porphyrin derivatives, styryl-based dyes, tetracene derivatives, pyrazolone derivatives, decacyclene, phenoxazone, and the like.

The light emitting layer 31 may be formed by a dry film forming method, a coating method, or the like. Examples of the dry film forming method and the coating method are similar to those in the case of the anode layer 20. The light emitting layer 31 is preferably formed by inkjet printing.

The device functional part 30 may have various functional layers in addition to the light emitting layer 31. Examples of the functional layer disposed between the anode layer 20 and the light emitting layer 31 include a hole injection layer, a hole transport layer, and the like. Examples of the functional layer disposed between the cathode layer 450 and the light emitting layer 31 include an electron injection layer, an electron transport layer, and the like. The electron injection layer may be a part of the cathode layer 50.

The hole injection layer is a functional layer having a function of improving the efficiency of hole injection from the anode layer 20 to the light emitting layer 31. The hole transport layer is a functional layer having a function of improving the efficiency of hole injection from the hole injection layer (anode layer in embodiment in which hole injection layer is not present) to the light emitting layer 31. The electron transport layer is a functional layer having a function of improving the efficiency of electron injection from the electron injection layer (cathode layer in embodiment in which electron injection layer is not present) to the light emitting layer 31. The electron injection layer is a functional layer having a function of improving the efficiency of electron injection from the cathode layer 50 to the light emitting layer 31.

The hole injection layer may be an inorganic layer or an organic layer. The hole injection material constituting the hole injection layer may be a low molecular compound or a high molecular compound.

Examples of the low molecular compound include: metal oxides such as vanadium oxide, molybdenum oxide, ruthenium oxide, and aluminum oxide; metal phthalocyanine compounds such as copper phthalocyanine; carbon, and the like.

Examples of the high molecular compound include polyaniline, polythiophene, and polythiophene derivatives such as polyethylene dioxythiophene (PEDOT), polypyrrole, polyphenylenevinylene, polythienylenevinylene, polyquinoline and polyquinoxaline, and derivatives thereof, conductive polymers such as polymers having an aromatic amine structure in a main chain or a side chain.

The optimum value of the thickness of the hole injection layer varies depending on a material to be used. The thickness of the hole injection layer may be appropriately determined in view of required properties, simplicity of film formation, and the like. The thickness of the hole injection layer is, for example, 1 nm to 1 µm, preferably 2 nm to 500 nm, and more preferably 5 nm to 200 nm.

The hole transport layer is an organic layer containing a hole transport material. The hole transport material is not limited as long as the hole transport material is an organic compound having a hole transport function. Examples of the organic compound having the hole transport function include polyvinyl carbazole or derivatives thereof, polysilane or derivatives thereof, polysiloxane derivatives having an aromatic amine residue in the side chain or the main chain, pyrazoline derivatives, arylamine derivatives, stilbene derivatives, triphenyldiamine derivatives, polyaniline or derivatives thereof, polythiophene or derivatives thereof, polypyrrole or derivatives thereof, polyarylamine or derivatives thereof, poly (p-phenylenevinylene) or derivatives thereof, polyfluorene derivatives, high molecular compounds having an aromatic amine residue, and poly (2,5-thienylenevinylene) or derivatives thereof.

Examples of the hole transport material include hole transport materials described in JP-A-63-70257, JP-A-63-175860, JP-A-2-135359, JP-A-2-135361, JP-A-2-209988, JP-A-3-37992, and JP-A-3-152184, and the like.

The optimum value of the thickness of the hole transport layer varies depending on a material to be used. The thickness of the hole transport layer may be appropriately determined in view of required properties, simplicity of film formation, and the like. The thickness of the hole transport layer is, for example, 1 nm to 1 µm, preferably 2 nm to 500 nm, and more preferably 5 nm to 200 nm.

The electron transport layer is an organic layer containing an electron transport material. Known materials may be used as the electron transport material. Examples of the electron transport material constituting the electron transport layer include oxadiazole derivatives, anthraquinodimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, metal complexes of 8-hydroxyquinoline or derivatives thereof, polyquinoline or derivatives thereof, polyquinoxaline or derivatives thereof, polyfluorene or derivatives thereof, and the like.

The thickness of the electron transport layer may be appropriately determined in view of required properties, simplicity of film formation, and the like. The thickness of the electron transport layer is, for example, 1 nm to 1 µm, preferably 2 nm to 500 nm, and more preferably 5 nm to 200 nm.

The electron injection layer may be an inorganic layer or an organic layer. As a material constituting the electron injection layer, an optimum material is appropriately selected according to the type of a light emitting layer. Examples of the material constituting the electron injection layer include an alkali metal, an alkaline earth metal, an alloy containing one or more types of alkali metals and alkaline earth metals, oxides, halides, and carbonates of the alkali metal or the alkaline earth metal or mixtures of these materials, and the like. Examples of the alkali metal and examples of the oxides, halides, and carbonates of the alkali metal include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, lithium carbonate and the like. Examples of the alkaline earth metal and examples of the oxides, halides, and carbonates of the alkaline earth metal include magnesium, calcium, barium, strontium, magnesium oxide, magnesium fluoride, calcium oxide, calcium fluoride, barium oxide, barium fluoride, strontium oxide, strontium fluoride, and magnesium carbonate.

In addition, a layer obtained by mixing a conventionally known organic material having an electron transporting property and an organic metal complex of an alkali metal can be used as the electron injection layer.

Examples of a layer configuration of the device functional part 30 will be described as follows. In the following examples of the layer configuration, both the anode layer and the cathode layer are described in parentheses in order to show the arrangement relationship between the anode layer, the cathode layer, and various functional layers.
(a) (anode layer) / light emitting layer / (cathode layer)
(b) (anode layer) /hole injection layer / light emitting layer / (cathode layer)
(c) (anode layer) / hole injection layer / light emitting layer / electron injection layer/ (cathode layer)
(d) (anode layer) / hole injection layer / light emitting layer / electron transport layer / electron injection layer / (cathode layer)
(e) (anode layer) / hole injection layer / hole transport layer / light emitting layer / (cathode layer)
(f) (anode layer) / hole injection layer / hole transport layer / light emitting layer / electron injection layer / (cathode layer)
(g) (anode layer) / hole injection layer / hole transport layer / light emitting layer / electron transport layer / electron injection layer / (cathode layer)
(h) (anode layer) / light emitting layer / electron injection layer / (cathode layer)
(i) (anode layer) / light emitting layer / electron transport layer / electron injection layer / (cathode layer)
The symbol "/" means that layers on both sides of the symbol "/" are bonded.

Functional layers included in the device functional part 30 other than the light emitting layer 31 may be formed by a method similar to that of the light emitting layer 31.

The number of the light emitting layers 31 included in the device functional part 30 may be one, or two or more. In any one of the layer configurations in the configuration examples (a) to (i) mentioned above, when the laminate disposed between the anode layer and the cathode layer is referred to as [structural unit I], the following layer configuration (j) is provided as a configuration of the device functional part 30 having two light emitting layer 31. The layer configurations of the two (structural units I) may be the same or different from each other.
(j) (anode layer) / [structural unit I] / charge generating layer / [structural unit I] / (cathode layer)

The charge generating layer is a layer that generates holes and electrons by the application of an electric field. Examples of the charge generating layer include thin films containing vanadium oxide, ITO, molybdenum oxide, or the like.

When "[structural unit I] / charge generating layer" is referred to as [structural unit II], the following layer configuration (k) is provided as a configuration of an organic EL device having three or more light emitting layers.
(k) (anode layer) / [structural unit II]x / [structural unit I] / (cathode layer)

The symbol "x" indicates an integer of 2 or more, and "[structural unit II] x" indicates a laminate in which [structural unit II] is laminated in x stages. The layer configurations of a plurality of [structural units II] may be the same or different from each other.

The device functional part 30 may be configured by directly laminating a plurality of light emitting layers 31 without providing the charge generating layer.

### [Non-Conductive Part Forming Step]

At a non-conductive part forming step, a non-conductive part 40 is formed on the entire predetermined region A. Fig. 3 illustrates a state where the non-conductive part 40 is also formed outside the predetermined region A. In the embodiment in which the predetermined region A is covered with the device functional part 30 at the device functional part forming step, the non-conductive part 40 is formed so as to cover the device functional part 30 on the predetermined region A. The non-conductive part 40 is formed on the entire predetermined region A.

An example of the material of the non-conductive part 40 is an insulating material. The non-conductive part 40 may be a cured product of a photosensitive resin composition. The material of the non-conductive part 40 may be a material included in one or more functional layers of the device functional part 30.

When the anode layer 20 has the eaves part 24, the eaves part 24 of the second conductive layer 22 is bent to the opposite side to the substrate 10 in a stage of shifting from the preparation step to the device functional part forming step, during the device function part forming step, or the like, so that a projection 25 that projects to the side opposite to the substrate 10 as illustrated in Fig. 4 may be formed. Alternatively, when the step of cleaning the substrate 2 with an electrode is performed between the preparation step and the device functional part forming step for example, the projection 25 may be formed at the cleaning step.

At the non-conductive part forming step, the non-conductive part 40 is formed so that the projection 25 is insulated from the cathode layer 50 to be formed at a cathode layer forming step to be described later. Specifically, the non-conductive part 40 is formed so as to embed the projection 25. A height t of the projection 25 (see Fig. 4) is, for example, 100 nm to 1 µm. The height t is, for example, 600 nm. As illustrated in Fig. 3 and Fig. 4, in the embodiment in which the non-conductive part 40 is formed after the device functional part 30 is formed, the non-conductive part 40 may be formed at a thickness that allows the projection 25 to be embedded in the device functional part 30 and the non-conductive part 40.

The non-conductive part 40 in which the projection 25 can be embedded may be designed, for example, as follows. For example, the size of the eaves part 24 is measured by using a spare (or test) substrate 2 with an electrode having the same configuration as the substrate 2 with an electrode used for producing the organic EL device 1. Based on the measurement result, the assumed shape of the projection 25 is estimated in advance. The non-conductive part 40 is designed so that the estimated projection 25 and the cathode layer 50 are insulated from each other.

The non-conductive part 40 may be formed by a coating method. Examples of the coating method may be similar to those exemplified in the method for forming the anode layer 20. Ink jet printing is preferred among the coating methods exemplified. The non-conductive part 40 may be formed by a manufacturer directly coating a coating solution containing the material of the non-conductive part 40 on the predetermined region A and drying the coating solution. In the embodiment in which the non-conductive part 40 is a cured product of a photosensitive resin composition, after the photosensitive resin composition to become the non-conductive part 40 is coated on the predetermined region A, the photosensitive resin composition is cured by light irradiation. As a result, the non-conductive part 40 is formed.

### [Cathode Layer Forming Step]

At a cathode layer forming step, the cathode layer 50 is formed on the device functional part 30. At the cathode layer forming step, the cathode layer 50 is formed so as to project from a side of the predetermined region A to the outside of the anode layer 20 when viewed from the thickness direction of the substrate 10. Consequently, the cathode layer 50 is formed so as to be disposed on the non-conductive part 40 on the predetermined region A, and a part of the cathode layer 50 is formed so as to contact the substrate 10. In the present embodiment, the cathode layer 50 may be formed, for example, so that the predetermined region A does not surround the device functional part 30.

The optimum value of the thickness of the cathode layer 50 varies depending on a material to be used. The thickness of the cathode layer 50 is set in view of electric conductivity, durability, and the like. The thickness of the cathode layer 50 is normally 10 nm to 10 µm, preferably 20 nm to 1 µm, and more preferably 50 nm to 500 nm.

The material of the cathode layer 50 is preferably a material having a high reflectance to light (particularly, visible light) from the light emitting layer 31 included in the device functional part 30 such that light from the device functional part 30 (specifically, light from light emitting layer) is reflected by the cathode layer 50 and travels toward a side of the anode layer 20. Examples of the material of the cathode layer 50 include an alkali metal, an alkaline earth metal, a transition metal, metals of group 13 of the periodic table, and the like. As the cathode layer 50, a transparent conductive electrode containing a conductive metal oxide, a conductive organic material, and the like may be used.

Examples of a method for forming the cathode layer 50 include an inkjet method, a slit coater method, gravure printing, screen printing, a coating method such as a spray coater method, a vacuum evaporation method, a sputtering method, a laminating method of thermocompression-bonding a metal thin film, and the like.

By forming the cathode layer 50 at the cathode layer forming step, the organic EL device 1 is obtained. The organic EL device 1 may further include a sealing member that seals the device functional part 30. The sealing member is a member for preventing moisture from entering the device functional part 30, and has a moisture barrier function. The sealing member is provided in the substrate 2 with an electrode so that a part of the anode layer 20 and the cathode layer 50 is exposed from the sealing member for external connection.

In a mode in which the organic EL device 1 further includes the sealing member, a sealing step of sealing the device functional part 30 by the sealing member may be further performed after the cathode layer forming step. At the sealing step, for example, the sealing member may be adhered to the substrate 2 with an electrode including the cathode layer 50 so as to seal the device functional part 30.

In the method for producing the organic EL device 1, the organic EL device 1 may be produced using an elongated substrate 2 with an electrode. The elongated substrate 2 with an electrode is a substrate in which the anode layer 20 is formed on each of a plurality of device forming regions that are virtually set at least along a longitudinal direction of the elongated substrate 10.

When the organic EL device 1 is produced using the elongated substrate 2 with an electrode described above, the device functional part forming step, the non-conductive part forming step, and the cathode layer forming step may be performed on each of the device forming regions while the substrate 2 with an electrode is conveyed in its longitudinal direction. In such an embodiment, by performing the cathode layer forming step, the organic EL device 1 is formed in each device forming region. Consequently, a plurality of the organic EL devices 1 can be obtained by individualizing the respective device forming regions from the substrate 2 with an electrode after the cathode layer formation step. In an embodiment including the sealing step, the individualizing step may be performed after the sealing step is performed. At least one of the steps in the method for producing the organic EL device 1 may be performed by a roll-to-roll system.

In a mode in which a layer constituting the device functional part 30 is formed by a coating method (for example, inkjet printing) while the elongated substrate 2 with an electrode is conveyed, the substrate 2 with an electrode is preferably horizontally conveyed by a conveyance mechanism. For example, the substrate 2 with an electrode may be horizontally conveyed by a plurality of rolls or may be horizontally conveyed using air by an air floating mechanism.

As illustrated in Fig. 3 and Fig. 4, the organic EL device 1 includes the substrate 10, the anode layer (first electrode layer) 20, the device functional part 30, the cathode layer (second electrode layer) 50, and the non-conductive part 40 that is disposed between the predetermined region A of the anode layer 20 and the cathode layer 50. The configuration and arrangement of the anode layer 20, the device functional part 30, the cathode layer 50, and the non-conductive part 40 have been described in the production method described above. In the organic EL device 1 of the present embodiment, one device functional part 30 is provided for the substrate 10.

Since the second conductive layer 22 of the anode layer 20 has the eaves part 24, the eaves part 24 may be deformed and thus the projection 25 (see Fig. 4) may be formed before the non-conductive part forming step in the method for producing the organic EL device 1. Depending on the height of the projection 25, the projection 25 cannot be covered with the device functional part 30 as illustrated in Fig. 4. For example, since the thickness of the device functional part 30 is normally less than 600 nm (for example, 200 nm), if the height of the projection 25 is 600 nm or more, a part of the projection 25 penetrates the device functional part 30.

Even in such a case, according to the method for producing the organic EL device (electronic device) 1, the non-conductive part 40 is formed on the predetermined region A at the non-conductive part forming step, and thus the non-conductive part 40 is formed on the projection 25. The anode layer 20 including the projection 25 is insulated from the cathode layer 50, and thus a short circuit between the anode layer 20 and the cathode layer 50, current leakage, and the like can be prevented. As a result, the organic EL device 1 with high reliability can be produced. By performing the non-conductive part forming step, the short circuit between the anode layer 20 and the cathode layer 50, the current leakage, and the like can be prevented. Consequently, the production yield of the organic EL device 1 is also improved.

In the embodiment in which the non-conductive part 40 is formed on the entire predetermined region A, it is not necessary to specify a location in the predetermined region A where the projection 25 is formed. For this reason, the organic EL device 1 in which defects including the short circuit caused by the projection 25 are prevented can be efficiently produced. Consequently, the production yield of the organic EL device 1 is further improved.

In the embodiment in which the non-conductive part 40 is a cured product of a photosensitive resin composition, the non-conductive part 40 can be easily formed while the substrate 2 with an electrode is conveyed. The organic EL device 1 can thus be produced efficiently.

### (Modification)

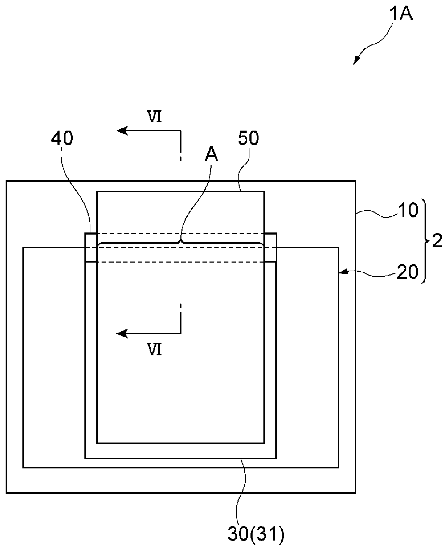

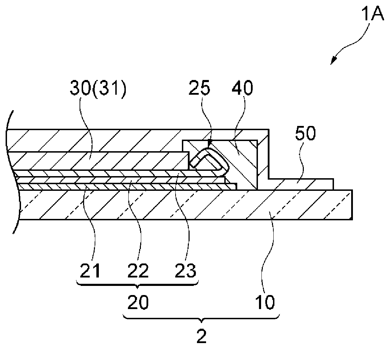

In the organic EL device 1 illustrated in Fig. 3 and Fig. 4, the device functional part 30 is formed so as to cover the predetermined region A when viewed from the thickness direction of the substrate 10. However, as in an organic EL device 1A illustrated in Fig. 5 and Fig. 6, the device functional part 30 may be disposed inside the anode layer 20 when viewed from the thickness direction of the substrate 10. In other words, when viewed from the thickness direction of the substrate 10, the surface of the anode layer 20 on which the device functional part 30 is formed includes a functional part forming region where the device functional part 30 is formed and a functional part not-forming region surrounding the functional part forming region, and the device functional part 30 may be formed only in the functional part forming region.

In this case, the non-conductive part 40 is disposed not only on the predetermined region A but also on a portion of the anode layer 20 between the device functional part 30 and the predetermined region A. Such an organic EL device 1A may be produced similarly to the organic EL device 1 except that the device functional part 30 is formed so as to be disposed inside the anode layer 20 when viewed from the thickness direction of the substrate 10 at the device functional part forming step, and the non-conductive part is formed not only on the predetermined region A but also on the portion of the anode layer 20 between the device functional part 30 and the predetermined region A at the non-conductive part forming step. Since the non-conductive part 40 is also disposed on the projection 25 in the method for producing the organic EL device 1A and the organic EL device 1A, operations and effects similar to those in the method for producing the organic EL device 1 and the organic EL device 1 are achieved.

The present modification has described the embodiment in which the device functional part 30 is formed inside. However, in the embodiment in which the device functional part 30 has one or a plurality of function layers, at least one functional layer included in the device functional part 30 may be disposed on the predetermined region A.

Various embodiments of the present invention have been described above. However, the present invention is not limited to the various embodiments illustrated, and is intended to include all modifications within the scope of the claims or the meaning and scope equivalent to the scope of the claims.

For example, it is not necessary to form the non-conductive part on the entire predetermined region. When the projection is formed in at least a part of the predetermined region, it is only required that the non-conductive part is formed on at least a part of the predetermined region. For example, when the projection can be visually checked, it is only required that the non-conductive part is formed only on the projection in the predetermined region. Alternatively, before the non-conductive part forming step is performed, for example, when the substrate with an electrode is prepared at the preparation step or immediately before the device functional part forming step is performed, an inspection step of measuring the shape of the predetermined region and its vicinity using a shape measurement device such as a step gauge may be performed, and the non-conductive part may be formed on the projection specified in the inspection. When the inspection step is performed as described above and the non-conductive part is formed by a coating method such as inkjet printing, the position of the projection, the height of the projection, and the like may be input to a coating device according to the inspection result, and the non-conductive part may be automatically formed so as to embed the projection.

The material, thickness, and the like of the non-conductive part are not limited as long as the non-conductive part insulates the first electrode layer from the second electrode layer to such an extent that the defects such as current leakage and a short circuit do not occur.

It is only required that the non-conductive part forming step is performed before the second electrode layer forming step. For example, the non-conductive part forming step may be performed before the device functional part forming step. In this case, the thickness of the non-conductive part may be a thickness that allows the projection to be embedded only in the non-conductive part, or may be a thickness that allows the projection to be embedded in the non-conductive part and the device functional part.

The method for producing an organic EL device is not limited to the case of producing an organic EL device that emits light from a side of a substrate, and is also applicable to a case of producing an organic EL device that emits light from the side opposite to the substrate. While the embodiment has been described in which the first electrode layer is the anode layer and the second electrode layer is the cathode layer, the first electrode layer may be the cathode layer and the second electrode layer may be the anode layer. The present invention is also applicable to organic electronic devices other than an organic EL device, for example, organic solar cells, organic photodetectors, organic transistors, and the like. The present invention is not limited to an electronic device using an organic material, and is also applicable to an electronic device using an inorganic material, such as a liquid crystal display.

### [Example]

Hereinafter, the present invention will be described more specifically with reference to an example and a comparative example. However, the present invention is not limited to the following example. In the description of the example and the comparative example, components corresponding to the components in the embodiments described above are denoted by the same reference numerals for convenience of description.

### (Example)

An organic EL device, which is an example of an electronic device, was produced by the following procedure.

First, the substrate 2 with an electrode in which the anode layer 20 was formed on the substrate 10 (see Figs. 1 to 4) was prepared. The substrate 10 was made of glass. The anode layer 20 included the metal oxide layer 23, the first conductive layer 21, and the second conductive layer 22. The metal oxide layer 23, the first conductive layer 21, and the second conductive layer 22 were laminated in the order of the metal oxide layer 23, the first conductive layer 21, and the second conductive layer 22 from the side of the substrate 10.

The shape of the anode layer 20 included in the substrate 2 with an electrode was measured with a step measurement device (FP-10 manufactured by Toho Technology Corp.). As a result, the eaves part 24 (see Fig. 2) was formed at the edge of the anode layer 20 including the predetermined region A (when viewed from thickness direction of the substrate 10, region in organic EL device where edge of anode layer 20 overlaps cathode layer 50), and the projection 25 (see Fig. 4) was formed at least in the predetermined region A. The height t of the projection 25 was 600 nm.

Next, a UV ozone treatment (surface treatment) was performed on the substrate 2 with an electrode for three minutes.

A hole injection layer having a thickness of 35 nm was then formed on the anode layer 20 so as to cover the predetermined region A of the anode layer 20. The material of the hole injection layer was a hole injection material containing a high molecular compound. The hole injection layer was formed by a spin coating method. Specifically, first, after a coating solution for a hole injection layer was supplied onto the anode layer 20, the substrate 2 with an electrode was rotated at a rotation speed of 1800 rpm for 20 seconds, so that a coating film for a hole injection layer was formed on the anode layer 20. The coating film for a hole injection layer was then heated and dried at a temperature of 100°C for four minutes using a hot plate, and further heated dried (fired) at a temperature of 100°C for four minutes using the hot plate, so that the hole injection layer was obtained.

Next, a hole transport layer having a thickness of 30 nm was formed on the hole injection layer. The material of the hole transport layer was a hole transport material containing a high molecular compound. The hole transport layer was formed by the spin coating method. Specifically, first, after a coating solution for a hole transport layer was supplied onto the hole injection layer, the substrate 2 with an electrode was rotated at a rotation speed of 2000 rpm for 10 seconds, so that a coating film for a hole transport layer was formed on the hole injection layer. Thereafter, the coating film for a hole transport layer was heated and dried at a temperature of 160°C for 60 minutes using the hot plate, so that the hole transport layer was obtained.

Next, a light emitting layer having a thickness of 75 nm was formed on the hole transport layer described above. The material of the light emitting layer was a light emitting material containing a high molecular compound. The light emitting layer was formed by the spin coating method. Specifically, first, after a coating solution for a light emitting layer was supplied onto the hole transport layer, the substrate 2 with an electrode was rotated at a rotation speed of 4500 rpm for 30 seconds, so that a coating film for a light emitting layer was formed on the hole transport layer. Thereafter, the coating film for a light emitting layer was heated and dried at a temperature of 130°C for 10 minutes using the hot plate, so that the light emitting layer was obtained.

Thereafter, an electron transport layer having a thickness of 10 nm was formed on the light emitting layer, and the non-conductive part 40 having a thickness of 10 µm was formed on the edge of the anode layer 20 including the predetermined region A. The material of the electron transport layer was an electron transport material containing a high molecular compound. The material of the non-conductive part was the material contained in the hole transport layer. The specific procedure of forming the electron transport layer and the non-conductive part 40 was as follows.

First, after a coating solution for an electron transport layer was supplied onto the light emitting layer, the substrate 2 with an electrode was rotated at a rotation speed of 2500 rpm for 30 seconds, so that a coating film for electron transport was formed on the light emitting layer. Subsequently, the material for the non-conductive part was dropped on the edge of the anode layer 20 (specifically, edge including predetermined region A) using a dropper, so that a non-conductive film was formed on the edge. The coating film for an electron transport layer and the non-conductive film were then heated and dried at a temperature of 130°C for 10 minutes using the hot plate, so that the electron transport layer and the non-conductive part 40 were obtained.

Subsequently, the cathode layer 50 was formed on the electron transport layer and the non-conductive part 40, so that the organic EL device of the example was obtained. Specifically, an NaF film having a thickness of 3 nm was formed on the electron transport layer and the non-conductive part 40 by a vacuum evaporation method, and then an Al film having a thickness of 200 nm was formed on the NaF film by the vacuum evaporation method, so that the cathode layer 50 having a two-layer structure was formed.

The organic EL device produced as described above was sealed using a glass member. At this time, the organic EL device was sealed with the glass member so that a part of the anode layer 20 and the cathode layer 50 was exposed from the sealing glass member for voltage supply. For convenience of description, the glass member is described as a separate member from the organic EL device. However, the glass member may be a part of the organic EL device.

A voltage of -5V (applied voltage in negative direction) was applied to the organic EL device produced in the example, and a leak current was measured. As a result, the leak current was -0.03A.

### (Comparative Example)

An organic EL device having the same configuration as the organic EL device of the example was produced except that the non-conductive part 40 was not provided. In a comparative example, the same substrate 2 with an electrode was prepared as in the example. Also in the comparative example, the shape of the anode layer 20 included in the substrate 2 with an electrode was measured by the same method as in the example. As a result, similarly to the case of the example, the eaves part 24 was formed at the edge of the anode layer 20 of the comparative example, the edge including the predetermined region A, and the projection 25 was formed at least in the predetermined region A. The height t of the projection 25 was 600 nm.

The organic EL device was produced using the substrate 2 with an electrode by the same method as the method for producing an organic EL device according to the example except for a method for forming an electron transport layer to be described later. The organic EL device of the comparative example was also sealed with a glass member as in the case of the example.

### [Method for Forming Electron Transport Layer]

A coating film for an electron transport layer was formed on the light emitting layer as in the example. Thereafter, the coating film for an electron transport layer was heated and dried at a temperature of 130°C for 10 minutes using a hot plate, so that an electron transport layer having a thickness of 10 nm was formed.

The leak current of the organic EL device of the comparative example was measured by the same method as in the example. As a result, the leak current was -0.72A.

### <Comparison of Example and Comparative Example>

As described in the example and the comparative example, the leak current of the organic EL device of the example was -0.03A, whereas the leak current of the organic EL device of the comparative example was -0.72A.

The projection 25 having a height of 600 nm was formed at the edge of the anode layer 20 in both the organic EL devices according to the example and the comparative example. The total thickness of the hole injection layer, the hole transport layer, the light emitting layer, and the electron transport layer formed on the edge of the anode layer 20 was 150 nm, which was smaller than the height of the projection 25, that is, 600 nm. It is thus considered in the comparative example that, the anode layer 20 and the cathode layer 50 cannot be sufficiently insulated due to the influence of the projection 25, and thus the leakage current increases.

On the other hand, in the example, as the non-conductive part 40 having a thickness of 10 µm was formed at the edge of the anode layer 20 including the predetermined region A, the projection 25 was covered with the non-conductive part 40. For this reason, even when the projection 25 was formed in the anode layer 20, the anode layer 20 and the cathode layer 50 could be sufficiently insulated, and thus the leakage current could be reduced.

That is, by forming the non-conductive part, it is possible to produce an electronic device that can more reliably achieve insulation between the first electrode layer (anode layer) and the second electrode layer (cathode layer).

### DESCRIPTION OF REFERENCE SIGNS

- 1,1A...: organic EL devices (electronic devices)
- 2...: substrate with an electrode
- 10...: substrate
- 20...: anode layer (first electrode layer)
- 21...: first conductive layer
- 22...: second conductive layer
- 23...: metal oxide layer
- 24...: eaves part
- 25...: projection
- 30...: device functional part
- 31...: light emitting layer (functional layer)
- 40...: non-conductive part
- 50...: cathode layer (second electrode layer)

## Claims

1. A method for producing an electronic device, comprising:
a preparation step of preparing a substrate with an electrode having a first electrode layer on a substrate, where the first electrode layer includes a first conductive layer and a second conductive layer that is disposed to be opposite to the substrate with respect to the first conductive layer, and an eaves part in which the second conductive layer projects outside the first conductive layer is formed in at least a part of a predetermined region of an edge of the first electrode layer when viewed from a thickness direction of the substrate;
a device functional part forming step of forming a device functional part including one or a plurality of functional layers on the first electrode layer included in the substrate with an electrode;
a second electrode layer forming step of forming a second electrode layer on the device functional part, where the second electrode layer is formed so that a part of the second electrode layer is disposed on the predetermined region; and
a non-conductive part forming step of forming a non-conductive part on the at least a part of the predetermined region before the second electrode layer forming step.

2. The method for producing an electronic device according to claim 1, wherein at the non-conductive part forming step, the non-conductive part is formed on an entire predetermined region.

3. The method for producing an electronic device according to claim 1 or 2, wherein at the device functional part forming step, the device functional part is formed inside the first electrode layer when viewed from a thickness direction of the substrate.

4. The method for producing an electronic device according to any one of claims 1 to 3, wherein at the non-conductive part forming step, the non-conductive part is formed so as to, if the eaves part is deformed and thus a projection is formed on an opposite side to the substrate, isolate the projection from the second electrode layer.

5. The method for producing an electronic device according to any one of claims 1 to 3, wherein
the second conductive layer has a projection on an opposite side to the substrate in the at least a part of the predetermined region, and
at the non-conductive part forming step, the non-conductive part is formed so as to isolate the projection from the second electrode layer.

6. The method for producing an electronic device according to any one of claims 1 to 5, wherein the non-conductive part contains an insulating material.

7. The method for producing an electronic device according to any one of claims 1 to 5, wherein at the non-conductive part forming step, the non-conductive part is formed by coating a photosensitive resin composition on the at least a part of the predetermined region and curing the photosensitive resin composition by light irradiation.

8. The method for producing an electronic device according to any one of claims 1 to 5, wherein a material of the non-conductive part is a material contained in one or a plurality of functional layers included in the device functional part.

9. The method for producing an electronic device according to any one of claims 1 to 8, wherein the first conductive layer contains at least one metal selected from the group consisting of silver, gold, aluminum, copper, iron, palladium, rhodium, titanium, chromium, and molybdenum or an alloy containing the one metal.

10. The method for producing an electronic device according to any one of claims 1 to 9, wherein the first electrode layer further includes a metal oxide layer between the first conductive layer and the substrate.

11. The method for producing an electronic device according to any one of claims 1 to 10, wherein
the preparation step includes
a step of forming a first material layer containing a same material as a material of the first conductive layer and a second material layer containing a same material as a material of the second conductive layer on the substrate in an order of the first material layer and the second material layer, and
a step of patterning the first material layer and the second material layer together into a predetermined pattern by etching, thus forming the first electrode layer, and
the material of the second conductive layer is a material having a lower etching rate than the material of the first conductive layer in the etching.

12. The method for producing an electronic device according to any one of claims 1 to 11, wherein at least one functional layer included in the device functional part is a light emitting layer containing an organic material.

13. An electronic device comprising:
a substrate;
a first electrode layer on the substrate;
a device functional part that is disposed on the first electrode layer and includes one or a plurality of function layers;
a second electrode layer that is disposed on the device functional part, where a part of the second electrode layer is disposed on a predetermined region of an edge of the first electrode layer; and
a non-conductive part between at least a part of the predetermined region and the second electrode layer, wherein
the first electrode layer includes
a first conductive layer, and
a second conductive layer disposed closer to the device functional part than the first conductive layer, and
the second conductive layer includes a projection on an opposite side to the substrate in the at least a part of the predetermined region.

14. The electronic device according to claim 13, wherein the non-conductive part is disposed on an entire predetermined region.

15. The electronic device according to claim 13 or 14, wherein the device functional part is disposed inside the first electrode layer when viewed from a thickness direction of the substrate.

16. The electronic device according to any one of claims 13 to 15, wherein the non-conductive part contains an insulating material.

17. The electronic device according to any one of claims 13 to 15, wherein the non-conductive part is a cured product of a photosensitive resin composition.

18. The electronic device according to any one of claims 13 to 15, wherein a material of the non-conductive part is a material contained in one or a plurality of functional layers included in the device functional part.

19. The electronic device according to any one of claims 13 to 18, wherein the first conductive layer contains one metal selected from the group consisting of silver, gold, aluminum, copper, iron, palladium, rhodium, titanium, chromium, and molybdenum or an alloy containing the one metal.

20. The electronic device according to any one of claims 13 to 19, wherein the first electrode layer further includes a metal oxide layer between the first conductive layer and the substrate.

21. The electronic device according to any one of claims 13 to 20, wherein at least one functional layer included in the device functional part is a light emitting layer containing an organic material.
